# EUROPEAN PATENT SPECIFICATION

(11) **EP 3 719 835 B1**
(45) Date of publication and mention of the grant of the patent: **12.10.2022**
(21) Application number: 20166360.6
(22) Date of filing: 27.03.2020
(51) Int. Cl.: G01R 31/28, H01L 21/67, H01L 21/677

(54) **INSPECTING DEVICE**
PRÜFVORRICHTUNG
DISPOSITIF D'INSPECTION

(30) Priority: 29.03.2019 JP 2019068623
(43) Date of publication of application: 07.10.2020
(73) Proprietor: Sintokogio, Ltd., Nagoya-shi, Aichi 450-6424 (JP)
(72) Inventor: HAMADA, Takayuki, Oharu-cho, Ama-gun, Aichi 4901144 (JP)
(74) Representative: Bittner, Thomas L.

(56) References cited:
- JP-A- S5 839 021
- KR-A- 20120 122 192
- US-A1- 2011 125 331
- US-A1- 2015 125 239

## Description

### Technical Field

The present invention relates to an inspecting device which inspects a device such as a semiconductor device. In particular, the present invention relates to an inspecting device which inspects a device in each of two or more environments that are different in condition.

### Background Art

In an inspection of a semiconductor device, it is sometimes required to carry out a static characteristic test and a dynamic characteristic test. JP 2016 / 206150 discloses an inspecting device which carries out such tests. Further, in an inspection of a semiconductor device, it is sometimes required to carry out tests in each of a room-temperature environment and a high-temperature environment. JP S58-39021 A and JP 4-23446 each disclose an inspecting device which carries out such tests.

Document US 2015 / 0125239 A1 refers to a device for transferring articles between an atmospheric pressure environment and a vacuum environment, the device comprising a transfer housing having an atmospheric transfer port, a pumping port, a vacuum transfer port, and a venting port disposed in a circumferentially-spaced relationship. The vacuum transfer port is in communication with the vacuum environment, and the atmospheric transfer port is in communication with the atmospheric pressure environment. The device can include a carrier disc rotatably disposed within the transfer housing, the carrier disc having a pocket formed in a sidewall thereof for holding an article. The device may further include an air bearing associated with the transfer housing and configured to expel gas to maintain a gap between the transfer housing and the carrier disc.

Document US 2011 / 0125331 A1 discloses a processing apparatus having: moveable parts disposed to form a predetermined processing environment within a processing chamber in which a predetermined processing is performed on an object to be processed; and a control means for controlling the operation of each of the moveable parts, abnormality inclusive of deterioration with time of the moveable parts constituting the processing apparatus is made to be easily judged. There is provided vibration detection means for detecting the waveforms of vibrations that occur accompanied by the operation of the moveable parts. When control is made from the control means in order to operate any one of the moveable parts, there are obtained event data corresponding to the control and the waveforms of vibrations of all the moveable parts that are operating simultaneously at the time in question. Each time the control corresponding to the event data is selected, or when a waveform of vibration corresponding to another event data of the same kind as that of the above-mentioned event data has been obtained, the change in the waveform is monitored. When the waveform has changed beyond a predetermined range, the processing apparatus is judged to be abnormal. A transfer robot is provided for transferring a substrate from a load lock chamber to each of a plurality of processing chambers.

Document KR 2012/0122192 A discloses an inspecting device configured for performing an electrical and optical test on LED chips comprised on a wafer. Both tests are performed in a respective electrical test station and optical test station.

### Summary of Invention

### Technical Problem

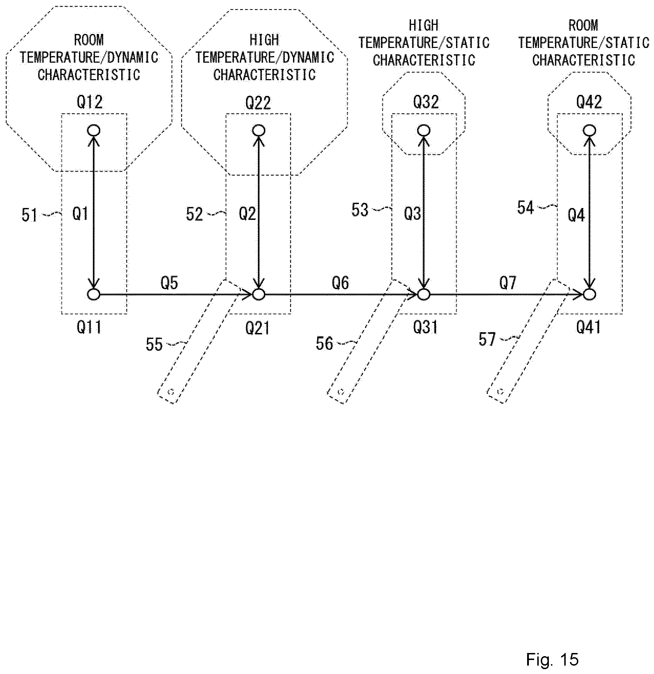

In a case where a semiconductor device is subjected to a static characteristic test and a dynamic characteristic test in each of a room-temperature environment and a high-temperature environment, a conveyance route Q along which the semiconductor device is conveyed is configured, for example, as illustrated in Fig. 15.

Use of the conveyance route Q as illustrated in Fig. 15 makes it possible to carry out (1) the dynamic characteristic test in the room-temperature environment, (2) the dynamic characteristic test in the high-temperature environment, (3) the static characteristic test in the high-temperature environment, and (4) the static characteristic test in the room-temperature environment, in this order. According to the conveyance route Q as illustrated in Fig. 15, the semiconductor device is conveyed as follows.

First, at a position Q11, the semiconductor device which has not been inspected is supplied to a first shuttle table 51.

The semiconductor device is then conveyed, by the first shuttle table 51, (1) from the position Q11 to a position Q12 and (2) from the position Q12 to the position Q11, along a within-table conveyance route Q1. At the position Q12, the dynamic characteristic test is carried out in the room-temperature environment.

Subsequently, the semiconductor device is transferred, by a first arm 55, from the first shuttle table 51 to a second shuttle table 52 along a between-table conveyance route Q5.

The semiconductor device is then conveyed, by the second shuttle table 52, (1) from a position Q21 to a position Q22 and (2) from the position Q22 to the position Q21, along a within-table conveyance route Q2. At the position Q22, the dynamic characteristic test is carried out in the high-temperature environment.

Subsequently, the semiconductor device is transferred, by a second arm 56, from the second shuttle table 52 to a third shuttle table 53 along a between-table conveyance route Q6.

The semiconductor device is then conveyed, by the third shuttle table 53, (1) from a position Q31 to a position Q32 and (2) from the position Q32 to the position Q31, along a within-table conveyance route Q3. At the position Q32, the static characteristic test is carried out in the high-temperature environment.

Subsequently, the semiconductor device is transferred, by a third arm 57, from the third shuttle table 53 to a fourth shuttle table 54 along a between-table conveyance route Q7.

The semiconductor device is then conveyed, by the fourth shuttle table 54, (1) from a position Q41 to a position Q42 and (2) from the position Q42 to the position Q41, along a within-table conveyance route Q4. At the position Q42, the static characteristic test is carried out in the room-temperature environment.

Finally, at the position Q41, the semiconductor device which has been inspected is collected from the fourth shuttle table 54.

The conveyance route Q thus configured includes the between-table conveyance routes Q5 through Q7. The shuttle tables 51 and 54, each of which functions as a room-temperature test station, need to be sufficiently spaced from the shuttle tables 52 and 53, each of which functions as a high-temperature test station. Therefore, each of the between-table conveyance routes Q5 through Q7 needs to be sufficiently long. Accordingly, an increase in size of an inspecting device and a decrease in inspection speed are inevitable. In particular, the conveyance route Q configured as described above includes three between-table conveyance routes, that is, the between-table conveyance routes Q5 through Q7. This causes the increase in size of the inspecting device and the decrease in inspection speed to be more serious.

Note that problems which arise in a case where tests are carried out in each of environments that are different in temperature condition have been described. However, similar problems can arise also in a case where tests are carried out in each of environments that are different in condition other than a temperature condition (for example, humidity condition, ambient condition, and the like). Note also that problems which arise in a case where a semiconductor device is tested have been described. However, similar problems can arise also in a case where a device other than the semiconductor device is tested. That is, it is possible to generalize the above problems as problems which can arise in a case where any device is tested in each of any environments that are different in condition.

An aspect of the present invention has been made in view of the above problems, and an object of an aspect of the present invention is to realize an inspecting device capable of efficiently testing a device in each of different environments, without causing an unnecessary increase in size of the inspecting device and an unnecessary decrease in inspection speed.

### Solution to Problem

For solving the problem, an inspecting device of claim 1 is provided.

In order to attain the above object, an inspecting device in accordance with an aspect of the present invention is an inspecting device including: a first index table; a second index table; an arm configured to conduct a device transferring operation of transferring a device between the first index table and the second index table; a first testing device configured to test, in a first environment, the device placed on the first index table; and a second testing device configured to test, in a second environment which is different from the first environment, the device placed on the second index table.

### Advantageous Effects of Invention

According to an aspect of the present invention, it is possible to realize an inspecting device which efficiently tests a device in each of different environments, without causing an unnecessary increase in size of the inspecting device and an unnecessary decrease in inspection speed.

### Brief Description of Drawings

- Fig. 1: is a perspective view illustrating an outline of a configuration of an inspecting device in accordance with an embodiment of the present invention.
- Fig. 2: is a plan view illustrating a conveyance route, along which a semiconductor device is conveyed, in the inspecting device illustrated in Fig. 1.
- Fig. 3: is a flow diagram illustrating a flow of a method of inspecting a semiconductor device with use of the inspecting device illustrated in Fig. 1.
- Fig. 4: is a plan view of a first index table included in the inspecting device illustrated in Fig. 1.
- Fig. 5: is a partial cross-sectional view of the first index table included in the inspecting device illustrated in Fig. 1.
- Fig. 6: is a plan view of a second index table included in the inspecting device illustrated in Fig. 1.
- Fig. 7: is a partial cross-sectional view of the second index table included in the inspecting device illustrated in Fig. 1.
- Fig. 8: is a plan view of an arm included in the inspecting device illustrated in Fig. 1.
- Fig. 9: is a side view of a device sucking head included in the arm included in the inspecting device illustrated in Fig. 1.
- Fig. 10: is a side view of a mount sucking head included in the arm included in the inspecting device illustrated in Fig. 1.
- Fig. 11: is a schematic view illustrating a flow of a method of replacing a mount put on the first index table included in the inspecting device illustrated in Fig. 1.
- Fig. 12: is a schematic view illustrating a flow of a method of replacing a mount put on the second index table included in the inspecting device illustrated in Fig. 1.
- Fig. 13: is a plan view illustrating a conveyance route, along which a semiconductor device is conveyed, in an inspecting device in accordance with a reference embodiment of the present invention.
- Fig. 14: is a plan view illustrating a conveyance route, along which a semiconductor device is conveyed, in an inspecting device in accordance with a reference embodiment of the present invention.
- Fig. 15: is a plan view illustrating a conveyance route, along which a semiconductor device is conveyed, in an inspecting device in accordance with a comparative example.

### Description of Embodiments

### [Outline of configuration of inspecting device]

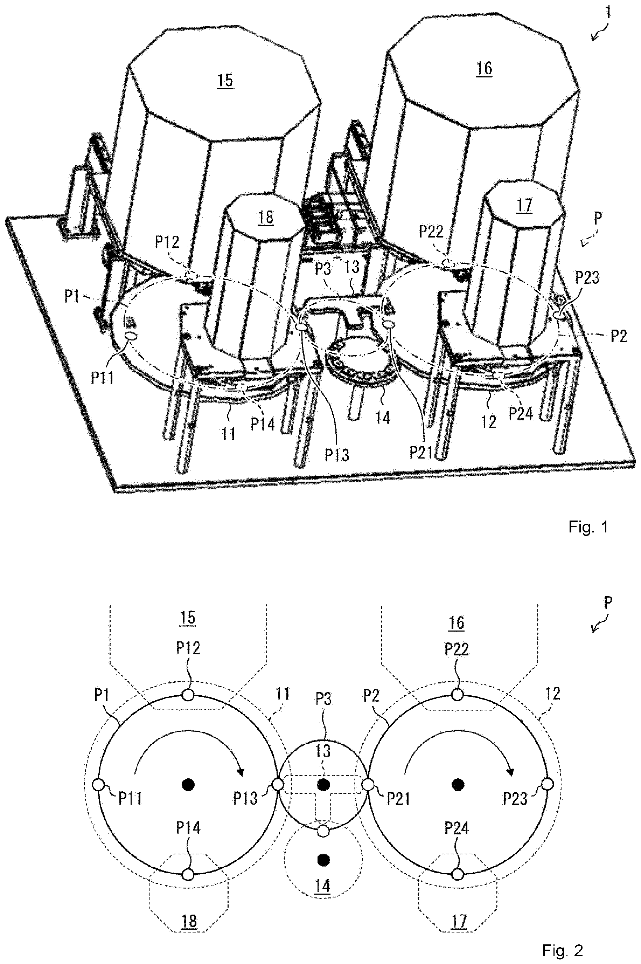

An outline of a configuration of an inspecting device 1 in accordance with an embodiment of the present invention will be described with reference to Fig. 1. Fig. 1 is a perspective view illustrating the outline of the configuration of the inspecting device 1.

The inspecting device 1 is a device for carrying out, with respect to a semiconductor device (an example of a "device" in the Claims), a static characteristic test and a dynamic characteristic test in each of a room-temperature environment (an example of a "first environment" in the Claims) and a high-temperature environment (an example of a "second environment" in the Claims). Note, here, that the high-temperature environment refers to an environment in which a temperature is higher than that in the room-temperature environment.

As illustrated in Fig. 1, the inspecting device 1 includes a first index table 11, a second index table 12, an arm 13, a mount collecting and supplying unit 14, a first testing device 15, a second testing device 16, a third testing device 17, and a fourth testing device 18.

The first index table 11 is a device for conveying the semiconductor device placed thereon along a first within-table conveyance route P1 having a circular shape. The first within-table conveyance route P1 is an example of a "first conveyance route" in the Claims. The first index table 11 has device placement regions in each of which a device is placed via a mount that is replaceable. On the first within-table conveyance route P1, first through fourth positions P11 through P14 are set at regular intervals. In particular, the third position P13 is set at a position on the first within-table conveyance route P1 which position is the closest to the second index table 12. The first index table 11 is rotated 90 degrees clockwise as viewed from above, thereby (1) conveying the semiconductor device at the first position P11 to the second position P12, (2) conveying the semiconductor device at the second position P12 to the third position P13, (3) conveying the semiconductor device at the third position P13 to the fourth position P14, and (4) conveying the semiconductor device at the fourth position P14 to the first position P11. Note that the third position P13 on the first within-table conveyance route P1 is an example of a "first position" in the Claims.

In the present embodiment, the first index table 11 functions as a room-temperature test station for carrying out the static characteristic test and the dynamic characteristic test in the room-temperature environment. Examples of the room-temperature environment include an environment in which it is possible to set a temperature of the semiconductor device to not lower than 20°C and not higher than 30°C. The inspecting device 1 is often installed inside a clean room. A room temperature inside the clean room is set to 25°C, for example. An actual room temperature is often not lower than 20°C and not higher than 30°C. As a result, the temperature of the semiconductor device placed on the first index table 11 is also not lower than 20°C and not higher than 30°C. The first index table 11 will be later described in detail with reference to other drawings.

The second index table 12 is a device for conveying the semiconductor device placed thereon along a second within-table conveyance route P2 having a circular shape. The second within-table conveyance route P2 is an example of a "second conveyance route" in the Claims. The second index table 12 has (i) device placement regions in each of which a device is placed via a mount that is replaceable and (ii) mount placement regions in each of which a spare mount is placed. On the second within-table conveyance route P2, first through fourth positions P21 through P24 are set. In particular, the first position P21 is set at a position on the second within-table conveyance route P2 which position is the closest to the first index table 11. The second index table 12 is rotated 90 degrees clockwise as viewed from above, thereby (1) conveying the semiconductor device at the first position P21 to the second position P22, (2) conveying the semiconductor device at the second position P22 to the third position P23, (3) conveying the semiconductor device at the third position P23 to the fourth position P24, and (4) conveying the semiconductor device at the fourth position P24 to the first position P21. Note that the first position P21 on the second within-table conveyance route P2 is an example of a "second position" in the Claims.

In the present embodiment, the second index table 12 functions as a high-temperature test station for carrying out the static characteristic test and the dynamic characteristic test in the high-temperature environment. Examples of the high-temperature environment include an environment in which it is possible to set the temperature of the semiconductor device to not lower than 50°C and not higher than 300°C. The second index table 12 will be later described in detail with reference to other drawings.

The arm 13 is a T-shaped rotary arm, and has a first device sucking head 13a, a second device sucking head 13b, and a mount sucking head 13c. The arm 13 carries out a device transferring operation with use of the first and second device sucking heads 13a and 13b. Note, here, that the device transferring operation refers to an operation of concurrently (i) transferring the semiconductor device placed on the first index table 11 to the second index table 12 with use of one of the first and second device sucking heads 13a and 13b and (ii) transferring another semiconductor device placed on the second index table 12 to the first index table 11 with use of the other of the first and second device sucking heads 13a and 13b. Furthermore, the arm 13 carries out a device collecting operation with use of one of the first and second device sucking heads 13a and 13b. Note, here, that the device collecting operation refers to an operation of collecting, from the first index table 11 or the second index table 12, a device which has been found to be a defective in any test. Moreover, the arm 13 carries out a mount collecting operation with use of the mount sucking head 13c. Note, here, that the mount collecting operation refers to an operation of collecting, from the first index table 11 or the second index table 12, a mount on which a device that has been found to be a defective in any test is placed. The arm 13 also carries out a mount putting operation with use of the mount sucking head 13c. Note, here, that the mount putting operation refers to an operation of putting, on the first index table 11 or the second index table 12, a spare mount obtained from the second index table 12 or the mount collecting and supplying unit 14 (later described). The arm 13 will be later described in detail with reference to other drawings.

The mount collecting and supplying unit 14 is a unit for (i) collecting a mount on which a device that has been found to be a defective in any test is placed and (ii) supplying a spare mount with which the mount is to be replaced.

The first testing device 15 is a device for carrying out, with respect to the semiconductor device placed on the first index table 11, the dynamic characteristic test in the room-temperature environment. In the present embodiment, at the second position P12 on the first within-table conveyance route P1, the dynamic characteristic test is carried out with respect to the semiconductor device by the first testing device 15.

The second testing device 16 is a device for carrying out, with respect to the semiconductor device placed on the second index table 12, the dynamic characteristic test in the high-temperature environment. In the present embodiment, at the second position P22 on the second within-table conveyance route P2, the dynamic characteristic test is carried out with respect to the semiconductor device by the second testing device 16.

The third testing device 17 is a device for carrying out, with respect to the semiconductor device placed on the second index table 12, the static characteristic test in the high-temperature environment. In the present embodiment, at the fourth position P24 on the second within-table conveyance route P2, the static characteristic test is carried out with respect to the semiconductor device by the third testing device 17.

The fourth testing device 18 is a device for carrying out, with respect to the semiconductor device placed on the first index table 11, the static characteristic test in the room-temperature environment. In the present embodiment, at the fourth position P14 on the first within-table conveyance route P1, the static characteristic test is carried out with respect to the semiconductor device by the fourth testing device 18.

Note that each of the first through fourth testing devices 15 through 18 can be realized by a publicly known configuration (for example, the configuration disclosed in Patent Literature 1). Therefore, the first through fourth testing devices 15 through 18 will not be described herein in detail.

### [Conveyance route for semiconductor device]

A conveyance route P, along which the semiconductor device is conveyed, in the inspecting device 1 will be described with reference to Fig. 2. Fig. 2 is a plan view illustrating a configuration of the conveyance route P.

The conveyance route P includes the first within-table conveyance route P1, the second within-table conveyance route P2, and the between-table conveyance route P3. The first within-table conveyance route P1 is a conveyance route along which the semiconductor device is conveyed by the first index table 11. The second within-table conveyance route P2 is a conveyance route along which the semiconductor device is conveyed by the second index table 12. The between-table conveyance route P3 is a conveyance route along which the semiconductor device is conveyed (transferred) by the arm 13.

According to the inspecting device 1, the semiconductor device is conveyed as follows.

First, the semiconductor device which has not been inspected is supplied to the position P11 on the first within-table conveyance route P1 by a device supplying unit (not illustrated in Fig. 1).

Next, by the first index table 11, the semiconductor device supplied to the first position P11 on the first within-table conveyance route P1 is (1) conveyed from the first position P11 to the second position P12 and (2) conveyed from the second position P12 to the third position P13, along the first within-table conveyance route P1.

The semiconductor device conveyed to the third position P13 on the first within-table conveyance route P1 is then conveyed (transferred), by the arm 13, to the first position P21 on the second within-table conveyance route P2 along the between-table conveyance route P3.

Subsequently, by the second index table 12, the semiconductor device conveyed to the first position P21 on the second within-table conveyance route P2 is (1) conveyed from the first position P21 to the second position P22, (2) conveyed from the second position P22 to the third position P23, (3) conveyed from the third position P23 to the fourth position P24, and (4) conveyed from the fourth position P24 to the first position P21, along the second within-table conveyance route P2.

The semiconductor device conveyed to the first position P21 on the second within-table conveyance route P2 is then conveyed (transferred), by the arm 13, to the third position P13 on the first within-table conveyance route P1 along the between-table conveyance route P3.

Next, by the first index table 11, the semiconductor device conveyed to the third position P13 on the first within-table conveyance route P1 is (1) conveyed from the third position P13 to the fourth position P14 and (2) conveyed from the fourth position P14 to the first position P11, along the first within-table conveyance route P1.

Finally, the semiconductor device which has been inspected and which has been conveyed to the first position P11 on the first within-table conveyance route P1 is collected by a device collecting unit (not illustrated in Fig. 1).

According to the inspecting device 1, the dynamic characteristic test and the static characteristic test are carried out in each of the room-temperature environment and the high-temperature environment with respect to the semiconductor device conveyed as described above. First, at the second position P12 on the first within-table conveyance route P1, the dynamic characteristic test is carried out in the room-temperature environment by the first testing device 15. Next, at the second position P22 on the second within-table conveyance route P2, the dynamic characteristic test is carried out in the high-temperature environment by the second testing device 16. Subsequently, at the fourth position P24 on the second within-table conveyance route P2, the static characteristic test is carried out in the high-temperature environment by the third testing device 17. Finally, at the fourth position P14 on the first within-table conveyance route P1, the static characteristic test is carried out in the room-temperature environment by the fourth testing device 18.

A between-table conveyance route included in the conveyance route P illustrated in Fig. 2 is merely the between-table conveyance route P3. Furthermore, it is possible to make a length of the between-table conveyance route P3 shorter than a length of a between-table conveyance route along which a semiconductor device is transferred between shuttle tables. Therefore, it is possible to carry out the static characteristic test and the dynamic characteristic test in each of the room-temperature environment and the high-temperature environment, without causing an unnecessary increase in size of the inspecting device 1 and an unnecessary decrease in inspection speed.

Note that an imaging test can be carried out with respect to the semiconductor device at each of the first position P11 and the third position P13 on the first within-table conveyance route P1 and the first position P21 and the third position P23 on the second within-table conveyance route P2. For example, in the imaging test at the first position P11 on the first within-table conveyance route P1, a camera (not illustrated) captures an image of the semiconductor device placed on the first index table 11. Then, a controller (not illustrated) (1) calculates, based on the image thus captured, a difference between (i) a position at which the semiconductor device is actually placed and (ii) a predetermined reference position and (2) adjusts, based on the difference thus calculated, a position of a probe of the first testing device 15.

This allows the first testing device 15 to suitably carry out the dynamic characteristic test, even in a case where the semiconductor device is placed at a position on the first index table 11 which position is deviated from the predetermined reference position. The imaging test can be similarly carried out also at each of the first position P21 on the second within-table conveyance route P2, the third position P23 on the second within-table conveyance route P2, and the third position P13 on the first within-table conveyance route P1. By carrying out the imaging test at each of these positions, it is possible to adjust a position of a probe of a corresponding one of the second testing device 16, the third testing device 17, and the fourth testing device 18, and accordingly possible to achieve an effect similar to that achieved by the above-described imaging test.

### [Flow of inspection method]

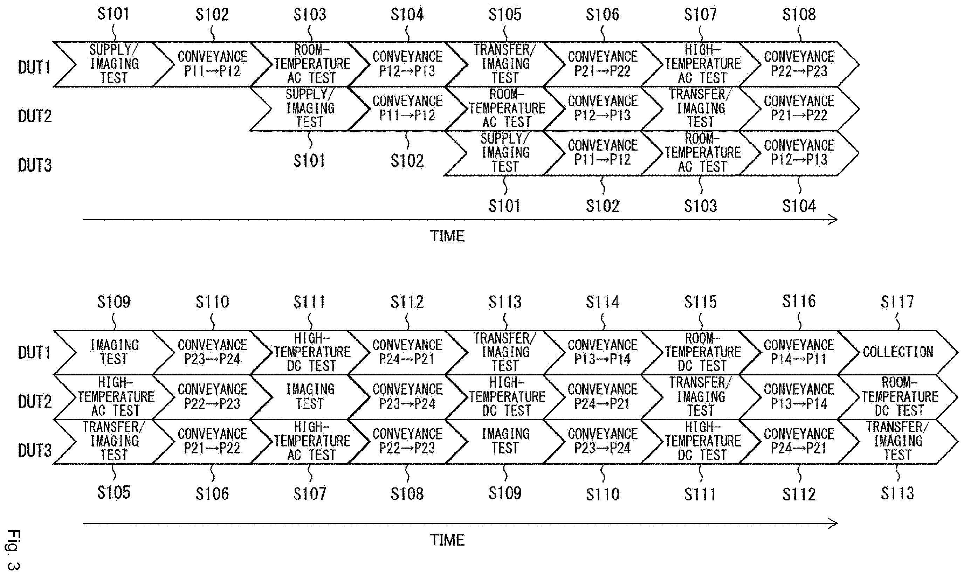

A flow of an inspection method S100 in which the inspecting device 1 is used will be described with reference to Fig. 3. Fig. 3 is a flow diagram illustrating a flow of the inspection method S100. Note that Fig. 3 illustrates, in a horizontal direction, a plurality of steps which are applied, in order, to a semiconductor device DUTi (i=1, 2, 3,...) and illustrates, in a vertical direction, a plurality of steps which are concurrently applied to a respective plurality of semiconductor devices DUT1, DUT2, DUT3,...

The inspection method S100 is an inspection method for testing a static characteristic and a dynamic characteristic of the semiconductor device in each of the room-temperature environment and the high-temperature environment with use of the above-described inspecting device 1. As illustrated in Fig. 3, the inspection method S100 includes a supply/imaging test step S101, a conveyance step S102, a room-temperature AC test step S103, a conveyance step S104, a transfer/imaging test step S105, a conveyance step S106, a high-temperature AC test step S107, a conveyance step S108, an imaging test step S109, a conveyance step S110, a high-temperature DC test step S111, a conveyance step S112, a transfer/imaging test step S113, a conveyance step S114, a room-temperature DC test step S115, a conveyance step S116, and a collection step S117.

The supply/imaging test step S101 is a step of supplying, at the first position P11 on the first within-table conveyance route P1, the semiconductor device DUT1 with use of the device supplying unit. Further, in this step, at the first position P11 on the first within-table conveyance route P1, the imaging test is carried out with respect to the semiconductor device DUT1 placed on the first index table 11, and the position of the probe of the first testing device 15 is adjusted based on a result of the imaging test.

The conveyance step S102 is a step of, by rotating the first index table 11 90 degrees, conveying the semiconductor device DUT1, placed on the first index table 11, from the first position P11 to the second position P12 along the first within-table conveyance route P1.

The room-temperature AC (dynamic characteristic) test step S103 is a step of carrying out, with respect to the semiconductor device DUT1 conveyed to the second position P12 on the first within-table conveyance route P1, the dynamic characteristic test in the room-temperature environment with use of the first testing device 15.

The conveyance step S104 is a step of, by rotating the first index table 11 90 degrees, conveying the semiconductor device DUT1, placed on the first index table 11, from the second position P12 to the third position P13 along the first within-table conveyance route P1.

The transfer/imaging test step S105 is a step of transferring, to the second index table 12 with use of the arm 13, the semiconductor device DUT1 conveyed to the third position P13 on the first within-table conveyance route P1. Further, in this step, at the first position P21 on the second within-table conveyance route P2, the imaging test is carried out with respect to the semiconductor device DUT1 transferred to the second index table 12. Based on a result of the imaging test, the position of the probe of the second testing device 16 is adjusted.

The conveyance step S106 is a step of, by rotating the second index table 12 90 degrees, conveying the semiconductor device DUT1, placed on the second index table 12, from the first position P21 to the second position P22 along the second within-table conveyance route P2.

The high-temperature AC test step S107 is a step of carrying out, with respect to the semiconductor device DUT1 conveyed to the second position P22 on the second within-table conveyance route P2, the dynamic characteristic test in the high-temperature environment with use of the second testing device 16.

The conveyance step S108 is a step of, by rotating the second index table 12 90 degrees, conveying the semiconductor device DUT1, placed on the second index table 12, from the second position P22 to the third position P23 along the second within-table conveyance route P2.

The imaging test step S109 is a step of, at the third position P23 on the second within-table conveyance route P2, carrying out the imaging test with respect to the semiconductor device DUT1 placed on the second index table 12. Further, in the imaging test step S109, the position of the probe of the third testing device 17 is adjusted based on a result of the imaging test.

The conveyance step S110 is a step of rotating the second index table 12 90 degrees. By carrying out the conveyance step S110, the semiconductor device DUT1, placed on the second index table 12, is conveyed from the third position P23 to the fourth position P24 along the second within-table conveyance route P2.

The high-temperature DC (static characteristic) test step S111 is a step of carrying out, with respect to the semiconductor device DUT1 conveyed to the fourth position P24 on the second within-table conveyance route P2, the static characteristic test in the high-temperature environment with use of the third testing device 17.

The conveyance step S112 is a step of, by rotating the second index table 12 90 degrees, conveying the semiconductor device DUT1, placed on the second index table 12, from the fourth position P24 to the first position P21 along the second within-table conveyance route P2.

The transfer/imaging test step S113 is a step of transferring, to the first index table 11 with use of the arm 13, the semiconductor device DUT1 conveyed to the first position P21 on the second within-table conveyance route P2. Further, in this step, at the third position P13 on the first within-table conveyance route P1, the imaging test is carried out with respect to the semiconductor device DUT1 transferred to the first index table 11. Based on a result of the imaging test, the position of the probe of the fourth testing device 18 is adjusted.

The conveyance step S114 is a step of rotating the first index table 11 90 degrees. By carrying out the conveyance step S114, the semiconductor device DUT1, placed on the first index table 11, is conveyed from the third position P13 to the fourth position P14 along the first within-table conveyance route P1.

The room-temperature DC test step S115 is a step of carrying out, with respect to the semiconductor device DUT1 conveyed to the fourth position P14 on the first within-table conveyance route P1, the static characteristic test in the room-temperature environment with use of the fourth testing device 18.

The conveyance step S116 is a step of rotating the first index table 11 90 degrees. By carrying out the conveyance step S116, the semiconductor device DUT1, placed on the first index table 11, is conveyed from the fourth position P14 to the first position P11 along the first within-table conveyance route P1.

The collection step S117 is a step of collecting, at the first position P11 on the first within-table conveyance route P1, the semiconductor device DUT1 with use of the device collecting unit.

Note that the above-described steps S101 through S117 are concurrently carried out with respect to the plurality of semiconductor devices DUT1, DUT2, DUT3,... For example, while the transfer/imaging test step S105 is being carried out with respect to the semiconductor device DUT1 which is the first semiconductor device, the room-temperature AC test step S103 is carried out with respect to the semiconductor device DUT2 which is the second semiconductor device, and the supply/imaging test step S101 is carried out with respect to the semiconductor device DUT3 which is the third semiconductor device. While the conveyance step S106 is being carried out with respect to the semiconductor device DUT1, the conveyance step S104 is carried out with respect to the semiconductor device DUT2, and the conveyance step S102 is carried out with respect to the semiconductor device DUT3.

### [Configuration of index table]

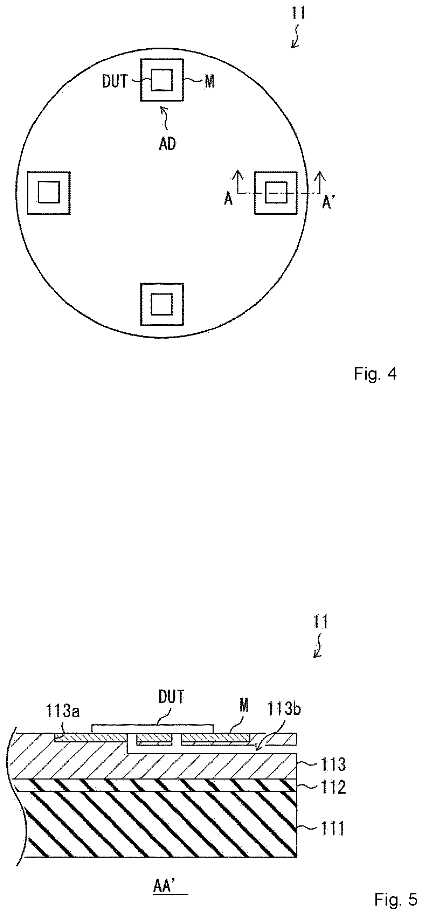

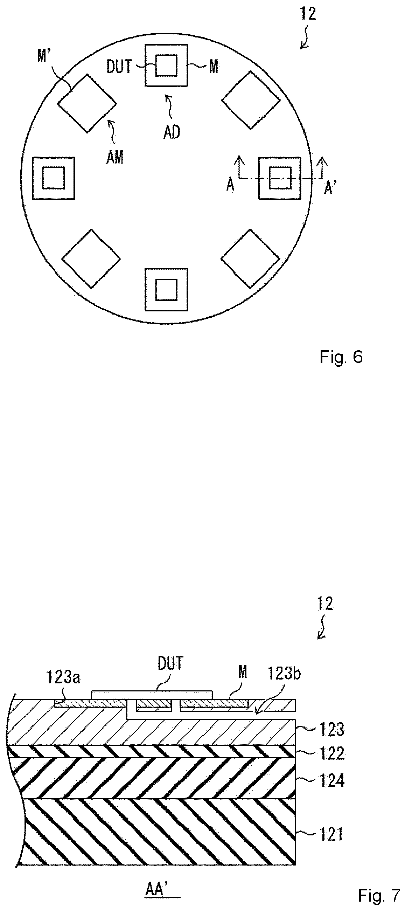

A configuration of the first index table 11 and a configuration of the second index table 12, which are included in the inspecting device 1, will be described with reference to Figs. 4 through 7. Fig. 4 is a plan view of the first index table 11. Fig. 5 is a partial cross-sectional view of the first index table 11. Fig. 6 is a plan view of the second index table 12. Fig. 7 is a partial cross-sectional view of the second index table 12.

As illustrated in Fig. 5, the first index table 11 is composed of a heat-resistant electrically insulating resin plate 111, a ceramic plate 112, and a stage block 113, which are stacked in this order. As illustrated in Figs. 4 and 5, the stage block 113 has, on an upper surface thereof, depressed parts 113a each of which functions as a device placement region AD. In each of the depressed parts 113a, a mount M is put, and a semiconductor device DUT is placed on the mount M. The mount M is a plate-shaped member made of a material having thermal conductivity and electrical conductivity (for example, metal). Further, the stage block 113 has, therein, air supply and exhaust passages 113b. Each of the air supply and exhaust passages 113b is, on one side, open in a corresponding one of the depressed parts 113a and communicated with through holes provided in the mount M. Each of the air supply and exhaust passages 113b is used as a flow passage through which air for sucking the semiconductor device DUT onto the mount M and air for floating the semiconductor device DUT from the mount M pass through.

As illustrated in Fig. 7, the second index table 12 is composed of a heat-resistant electrically insulating resin plate 121, a heater block 124, a ceramic plate 122, and a stage block 123 which are stacked in this order. As illustrated in Figs. 6 and 7, the stage block 123 has, on an upper surface thereof, depressed parts 123a each of which functions as the device placement region AD. In each of the depressed parts 123a, the mount M is put, and the semiconductor device DUT is placed on the mount M. The mount M is a plate-shaped member made of a material having thermal conductivity and electrical conductivity (for example, metal). Further, the stage block 123 has, therein, air supply and exhaust passages 123b. Each of the air supply and exhaust passages 123b is, on one side, open in a corresponding one of the depressed parts 123a and communicated with the through holes provided in the mount M. Each of the air supply and exhaust passages 123b is used as a flow passage through which air for sucking the semiconductor device DUT onto the mount M and air for floating the semiconductor device DUT from the mount M pass through.

The stage block 123 further has, on the upper surface thereof, depressed parts each of which functions as a mount placement region AM. In each of the depressed parts, a spare mount M' is put. A size and a material of the spare mount M' are identical to those of the mount M, and the mount M and the spare mount M' are replaceable with each other.

The heater block 124 embedded in the second index table 12 is used to heat the semiconductor device DUT placed in the device placement region AD. This makes it possible to test the semiconductor device DUT in the high-temperature environment without using an external heat source. The heater block 124 embedded in the second index table 12 is also used to heat the spare mount M' placed in the mount placement region AM. This makes it possible to keep the spare mount M' at a high temperature without using an external heat source. In other words, it is possible to replace the mount M with the spare mount M' without waiting for the spare mount M' to reach a high temperature, when it becomes necessary to replace the mount M with the spare mount M'.

### [Configuration of arm]

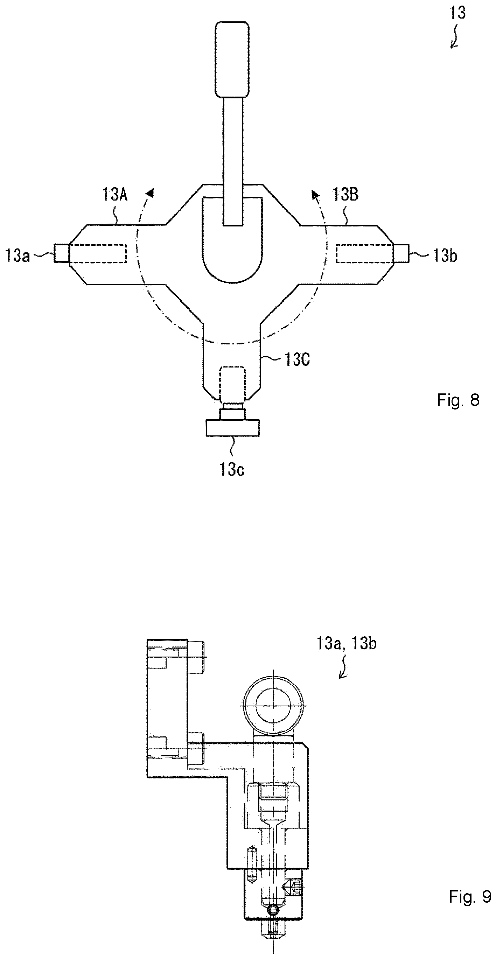

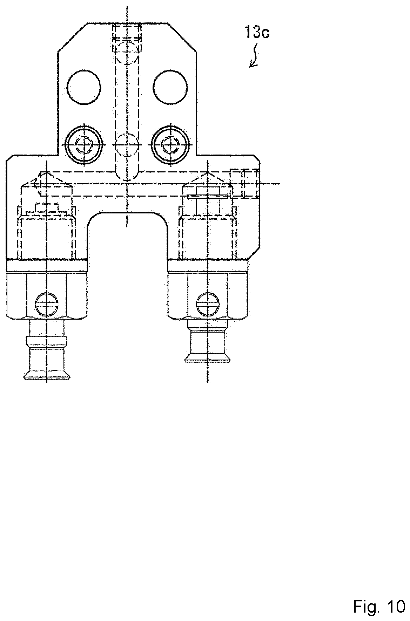

A configuration of the arm 13 included in the inspecting device 1 will be described with reference to Figs. 8 through 10. Fig. 8 is a plan view of the arm 13. Fig. 9 is a side view of each of the first and second device sucking heads 13a and 13b included in the arm 13. Fig. 10 is a side view of the mount sucking head 13c included in the arm 13.

As illustrated in Fig. 8, the arm 13 has a planar shape and is composed of three linear parts, that is, first through third linear parts 13A through 13C which are combined in the form of a letter "T". The first device sucking head 13a is attached to a back surface of an extreme end of the first linear part 13A which extends in a first direction from a rotation center of the arm 13. The second device sucking head 13b is attached to a back surface of an extreme end of the second linear part 13B which extends, from the rotation center of the arm 13, in a second direction that is an opposite direction from the first direction. The mount sucking head 13c is attached to a back surface of an extreme end of the third linear part 13C which extends, from the rotation center of the arm 13, in a third direction that is perpendicular to both of the first direction and the second direction.

As illustrated in Fig. 9, each of the first and second device sucking heads 13a and 13b has a structure suitable to suck the semiconductor device. As illustrated in Fig. 10, the mount sucking head 13c has a structure suitable to suck the mount. Each of the first and second device sucking heads 13a and 13b and the mount sucking head 13c can be a publicly known sucking pad. Therefore, the structure of each of the first and second device sucking heads 13a and 13b and the mount sucking head 13c will not be described in detail.

Note that the arm 13 can be alternatively configured in the form of a cross. In this case, it is possible to attach a further head to a back surface of an extreme end of a fourth linear part of the arm 13.

The further head can be, for example, a third device sucking head. In this case, it is considered to use the first device sucking head 13a and the second device sucking head 13b for the device transferring operation and use the third device sucking head for the device collecting operation. This makes it unnecessary to conduct the device transferring operation with use of the third device sucking head, which is likely to be damaged in the device collecting operation.

Alternatively, the further head can be, for example, an air blowing head. In this case, it is possible to, for example, remove, with use of air blown from the air blowing head, a foreign matter adhering to the mount.

### [Mount replacement method on first index table]

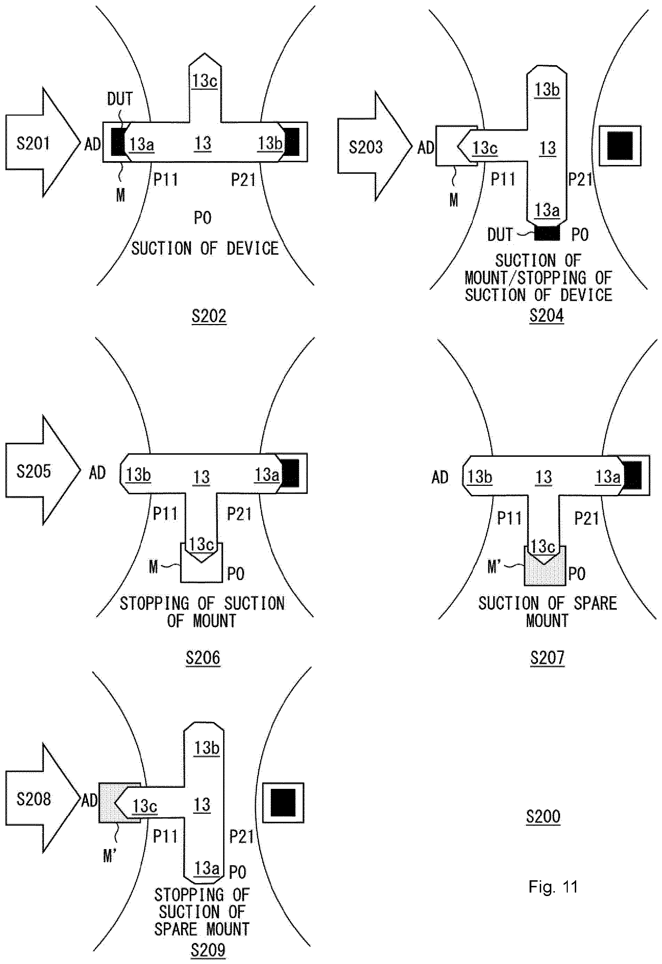

A case is assumed where the semiconductor device DUT, placed in the device placement region AD of the first index table 11 via the mount M, has been found to be a defective in any of the tests carried out in the room-temperature environment. The inspecting device 1 has a function of, in such a case, replacing the mount M with the spare mount M' supplied by the mount collecting and supplying unit 14. A flow of this mount replacement method S200 will be described with reference to Fig. 11. Fig. 11 is a schematic view illustrating a flow of the mount replacement method S200.

The mount replacement method S200 includes a rotation step S201, a device suction step S202, a rotation step S203, a mount suction/device suction stop step S204, a rotation step S205, a mount suction stop step S206, a spare mount suction step S207, a rotation step S208, and a spare mount suction stop step S209, as illustrated in Fig. 11. These steps S201 through S209 are carried out in a state where the device placement region AD is located at the third position P13 on the first within-table conveyance route P1.

The rotation step S201 is a step of rotating the arm 13 so that the first device sucking head 13a is located at the third position P13 on the first within-table conveyance route P1.

The device suction step S202 is a step of, at the third position P13 on the first within-table conveyance route P1, causing the first device sucking head 13a to suck the semiconductor device DUT.

The rotation step S203 is a step of rotating the arm 13 so that the first device sucking head 13a is located at a given position P0 and the mount sucking head 13c is located at the third position P13 on the first within-table conveyance route P1.

The mount suction/device suction stop step S204 is a step of (i) at the third position P13 on the first within-table conveyance route P1, causing the mount sucking head 13c to suck the mount M and (ii) at the given position P0, causing the first device sucking head 13a to stop sucking the semiconductor device DUT. Note that a device collection tray is disposed at the given position P0 and the semiconductor device DUT is held in the device collection tray.

The rotation step S205 is a step of rotating the arm 13 so that the mount sucking head 13c is located at the given position P0.

The mount suction stop step S206 is a step of, at the given position P0, causing the mount sucking head 13c to stop sucking the mount M. Note that the mount collecting and supplying unit 14 is disposed at the given position P0 and the mount M is collected by the mount collecting and supplying unit 14.

By the steps S201 through S206, the device collecting operation of collecting the semiconductor device DUT from the first index table 11 and the mount collecting operation of collecting the mount M from the first index table 11 are realized.

The spare mount suction step S207 is a step of, at the given position P0, causing the mount sucking head 13c to suck the spare mount M'. Note that the mount collecting and supplying unit 14 is disposed at the given position P0 and the spare mount M' is supplied by the mount collecting and supplying unit 14.

The rotation step S208 is a step of rotating the arm 13 so that the mount sucking head 13c is located at the third position P13 on the first within-table conveyance route P1.

The spare mount suction stop step S209 is a step of, at the third position P13 on the first within-table conveyance route P1, causing the mount sucking head 13c to stop sucking the spare mount M'.

By the steps S207 through S209, a spare mount putting operation of putting the spare mount M' on the first index table 11 is realized.

### [Mount replacement method on second index table]

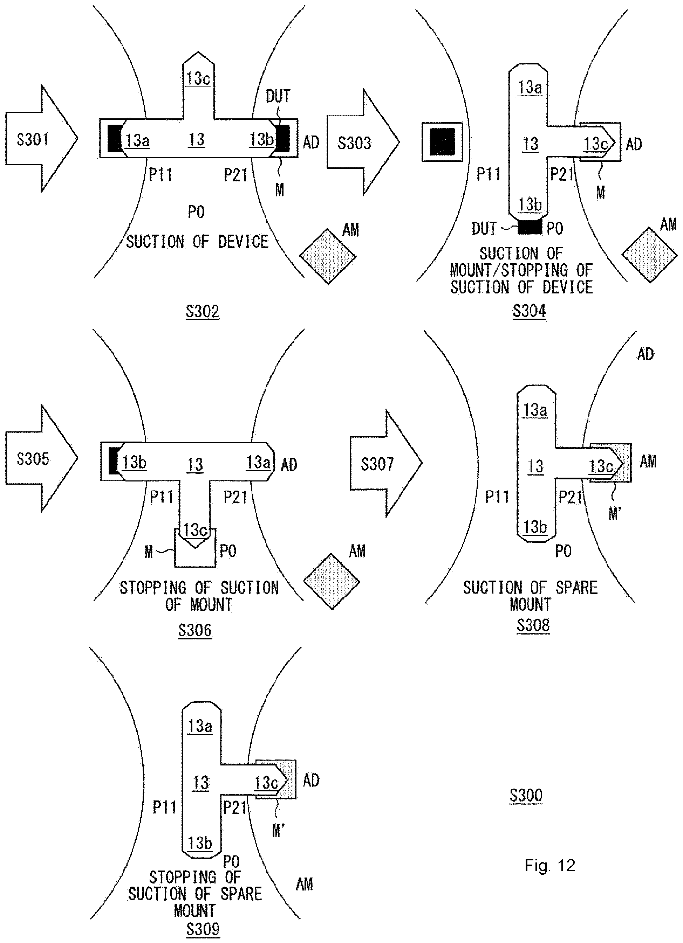

A case is assumed where the semiconductor device DUT, placed in the device placement region AD of the second index table 12 via the mount M, has been found to be a defective in any of the tests carried out in the high-temperature environment. The inspecting device 1 has a function of, in such a case, replacing the mount M with the spare mount M' placed in the mount placement region AM of the second index table 12. A flow of this mount replacement method S300 will be described with reference to Fig. 12. Fig. 12 is a schematic view illustrating a flow of the mount replacement method S300.

The mount replacement method S300 includes a rotation step S301, a device suction step S302, a rotation step S303, a mount suction/device suction stop step S304, a rotation step S305, a mount suction stop step S306, a rotation step S307, a spare mount suction step S308, and a spare mount suction stop step S309, as illustrated in Fig. 12. These steps S301 through S306 are carried out in a state where the device placement region AD is located at the first position P21 on the second within-table conveyance route P2.

The rotation step S301 is a step of rotating the arm 13 so that the second device sucking head 13b is located at the first position P21 on the second within-table conveyance route P2.

The device suction step S302 is a step of, at the first position P21 on the second within-table conveyance route P2, causing the second device sucking head 13b to suck the semiconductor device DUT.

The rotation step S303 is a step of rotating the arm 13 so that the second device sucking head 13b is located at the given position P0 and the mount sucking head 13c is located at the first position P21 on the second within-table conveyance route P2.

The mount suction/device suction stop step S304 is a step of (i) at the first position P21 on the second within-table conveyance route P2, causing the mount sucking head 13c to suck the mount M and (ii) at the given position P0, causing the second device sucking head 13b to stop sucking the semiconductor device DUT. Note that the device collection tray is disposed at the given position P0 and the semiconductor device DUT is held in the device collection tray.

The rotation step S305 is a step of rotating the arm 13 so that the mount sucking head 13c is located at the given position P0.

The mount suction stop step S306 is a step of, at the given position P0, causing the mount sucking head 13c to stop sucking the mount M. Note that the mount collecting and supplying unit 14 is disposed at the given position P0 and the mount M is collected by the mount collecting and supplying unit 14.

By the steps S301 through S306, the device collecting operation of collecting the semiconductor device DUT from the second index table 12 and the mount collecting operation of collecting the mount M from the second index table 12 are realized.

The rotation step S307 is a step of rotating the arm 13 so that the mount sucking head 13c is located at the first position P21 on the second within-table conveyance route P2.

The spare mount suction step S308 is a step of, at the first position P21 on the second within-table conveyance route P2, causing the mount sucking head 13c to suck the spare mount M'. The spare mount suction step S308 is carried out after a state is realized in which the mount placement region AM in which the spare mount M' is placed is located at the first position P21 on the second within-table conveyance route P2 by rotation of the second index table 12.

The spare mount suction stop step S309 is a step of, at the first position P21 on the second within-table conveyance route P2, causing the mount sucking head 13c to stop sucking the spare mount M'. The spare mount suction stop step S309 is carried out after a state is realized in which the device placement region AD in which the mount M was placed is located at the first position P21 on the second within-table conveyance route P2 by rotation of the second index table 12.

By the steps S307 through S309, the spare mount putting operation of putting the spare mount M' on the second index table 12 is realized.

### [Variation of inspecting device]

Note that although the configuration in which the dynamic characteristic test is carried out at the second position P12 on the first within-table conveyance route P1 and the static characteristic test is carried out at the fourth position P14 on the first within-table conveyance route P1 is employed in the present embodiment, the present invention is not limited to such a configuration. For example, a configuration in which the static characteristic test is carried out at the second position P12 on the first within-table conveyance route P1 and the dynamic characteristic test is carried out at the fourth position P14 on the first within-table conveyance route P1 can be alternatively employed. Note, however, that, according to the configuration in accordance with the present embodiment, the dynamic characteristic test is not carried out in the last place. Therefore, the configuration in accordance with the present embodiment has an advantage that it is possible to detect, by a subsequent test, a defect in the semiconductor device which defect has been caused by the dynamic characteristic test.

Note also that although the configuration in which the dynamic characteristic test is carried out at the second position P22 on the second within-table conveyance route P2 and the static characteristic test is carried out at the fourth position P24 on the second within-table conveyance route P2 is employed in the present embodiment, the present invention is not limited to such a configuration. For example, a configuration in which the static characteristic test is carried out at the second position P22 on the second within-table conveyance route P2 and the dynamic characteristic test is carried out at the fourth position P24 on the second within-table conveyance route P2 can be alternatively employed.

Note also that although the configuration in which the tests are carried out in the room-temperature environment on the first within-table conveyance route P1 and the tests are carried out in the high-temperature environment on the second within-table conveyance route P2 is employed in the present embodiment, the present invention is not limited to such a configuration. For example, a configuration in which the tests are carried out in the high-temperature environment on the first within-table conveyance route P1 and the tests are carried out in the room-temperature environment on the second within-table conveyance route P2 can be alternatively employed. Note, however, that, according to the configuration in accordance with the present embodiment, any of the tests is not carried out in the high-temperature environment in the last place. Therefore, the configuration in accordance with the present embodiment has an advantage that it is possible to detect, by a subsequent test, a defect in the semiconductor device which defect has been caused by any of such high-temperature tests.

Note also that although the configuration in which the tests are carried out at the respective positions P12 and P14 on the first within-table conveyance route P1 is employed in the present embodiment, the present invention is not limited to such a configuration. For example, a configuration in which the tests are carried out at a single position on the first within-table conveyance route P1 can be alternatively employed. Alternatively, a configuration in which tests are carried out at three or more positions on the first within-table conveyance route P1 can be employed. In this case, a test carried out at each of the three or more positions can be the static characteristic test, the dynamic characteristic test, or any other test.

Note also that although the configuration in which the tests are carried out at the respective positions P22 and P24 on the second within-table conveyance route P2 is employed in the present embodiment, the present invention is not limited to such a configuration. For example, a configuration in which the tests are carried out at a single position on the second within-table conveyance route P2 can be alternatively employed. Alternatively, a configuration in which tests are carried out at three or more positions on the second within-table conveyance route P2 can be employed. In this case, a test carried out at each of the three or more positions can be the static characteristic test, the dynamic characteristic test, or any other test.

Note also that although the configuration in which the inspecting device 1 includes two index tables, that is, the index tables 11 and 12 and a single arm, that is, the arm 13 is employed in the present embodiment, the present invention is not limited to such a configuration. That is, a configuration in which the inspecting device 1 includes N index tables and an N-1 arm(s), where N is any natural number of two or more, can be alternatively employed. In this case, an i-th arm is used to transfer the semiconductor device from an i-th index table to an i+1-th index table. Further, in this case, an environment of the tests carried out on one of adjacent index tables is different from that of the tests carried out on the other of the adjacent index tables. For example, in a case where the inspecting device 1 includes three index tables, the tests are carried out in a low-temperature environment on the first index table, the tests are carried out in the room-temperature environment on the second index table, and the tests are carried out in the high-temperature environment on the third index table. Alternatively, the tests are carried out in the room-temperature environment on the first index table, the tests are carried out in the high-temperature environment on the second index table, and the tests are carried out in the room-temperature environment on the third index table. Note that the semiconductor device can be transferred from an index table on which the tests are carried out in the room-temperature environment to an index table on which the tests are carried out in the high-temperature environment, by hand, instead of the arm.

Note also that although, in the present embodiment, the semiconductor device is inspected by the inspecting device 1, the present invention is not limited to the semiconductor device. Any device which needs to be tested in each of environments that are different in condition (in the present embodiment, environments that are different in temperature) can be an object to be inspected by the inspecting device 1.

### [Reference embodiment 1]

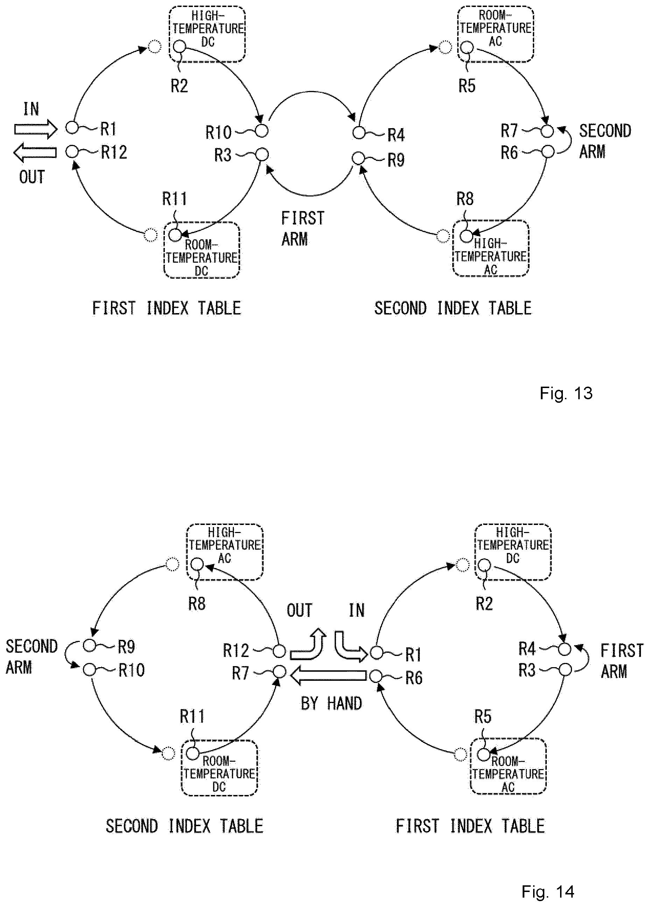

Note that it is also possible to realize a conveyance route as illustrated in Fig. 13 with use of an inspecting device including two index tables.

According to a conveyance route illustrated in Fig. 13, a semiconductor device is conveyed in the following order: position R1 → position R2 → position R3 (so far, conveyed by a first index table) → position R4 (so far, transferred by a first arm) → position R5 → position R6 (so far, conveyed by a second index table) → position R7 (transferred by a second arm) → position R8 → position R9 (so far, conveyed by the second index table) → position R10 (transferred by the first arm) → position R11 → position R12 (so far, conveyed by the first index table). According to this conveyance route, (1) a static characteristic test is carried out in a high-temperature environment at the position R2, (2) a dynamic characteristic test is carried out in a room-temperature environment at the position R5, (3) the dynamic characteristic test is carried out in the high-temperature environment at the position R8, and (4) the static characteristic test is carried out in the room-temperature environment at the position R11.

In the above-described embodiment, which one of the index tables is used to carry out the tests is determined depending on a test environment (the high-temperature environment or the room-temperature environment). In contrast, in the reference embodiment 1, which one of the index tables is used to carry out the tests is determined depending test contents (the static characteristic test or the dynamic characteristic test). In other words, it is possible to express the inspecting device in accordance with the reference embodiment 1 as follows: an inspecting device including: a first index table; a second index table; an arm configured to conduct a device transferring operation of transferring a device between the first index table and the second index table; a first testing device configured to carry out, with respect to the device placed on the first index table, a test having first test contents; and a second testing device configured to carry out, with respect to the device placed on the second index table, a test having second test contents which are different from the first test contents.

### [Reference embodiment 2]

Note that it is also possible to realize a conveyance route as illustrated in Fig. 14 with use of an inspecting device including two index tables.

According to a conveyance route illustrated in Fig. 14, a semiconductor device is conveyed in the following order: position R1 → position R2 → position R3 (so far, conveyed by a first index table) → position R4 (transferred by a first arm) → position R5 → position R6 (so far, conveyed by a second index table) → position R7 (transferred by hand) → position R8 → position R9 (so far, conveyed by the second index table) → position R10 (transferred by a second arm) → position R11 → position R12 (so far, conveyed by the first index table). According to this conveyance route, (1) a static characteristic test is carried out in a high-temperature environment at the position R2, (2) a dynamic characteristic test is carried out in a room-temperature environment at the position R5, (3) the dynamic characteristic test is carried out in the high-temperature environment at the position R8, and (4) the static characteristic test is carried out in the room-temperature environment at the position R11.

The reference embodiment 2 is characterized in that the semiconductor device is transferred from the first index table to the second index table by hand. Also in the reference embodiment 2, it is possible to carry out the static characteristic test in the high-temperature environment, the dynamic characteristic test in the room-temperature environment, the dynamic characteristic test in the high-temperature environment, and the static characteristic test in the room-temperature environment in this order, as in the reference embodiment 1.

### [Recap]

An inspecting device in accordance with a first aspect of the present invention is an inspecting device including: a first index table; a second index table; an arm configured to conduct a device transferring operation of transferring a device between the first index table and the second index table; a first testing device configured to test, in a first environment, the device placed on the first index table; and a second testing device configured to test, in a second environment which is different from the first environment, the device placed on the second index table.

According to the above aspect, index tables are used to convey a device. This makes it possible to (i) cause a between-table conveyance route to be shorter and (ii) reduce the number of times the device is conveyed (transferred) between the index tables. Therefore, according to the above aspect, it is possible to realize an inspecting device which efficiently tests a device in each of different environments, without causing an unnecessary increase in size of the inspecting device and an unnecessary decrease in inspection speed.

An inspecting device in accordance with a second aspect of the present invention employs the following configuration, in addition to the configuration of the inspecting device in accordance with the first aspect. That is, the inspecting device in accordance with the second aspect employs a configuration in which, in the device transferring operation, the arm obtains, at a first position, the device from the first index table and places, at a second position, the device on the second index table; the first position is a position on a first conveyance route which position is the closest to the second index table, the first conveyance route being a conveyance route along which the device is conveyed by the first index table; and the second position is a position on a second conveyance route which position is the closest to the first index table, the second conveyance route being a conveyance route along which the device is conveyed by the second index table.

According to the above aspect, it is possible to minimize a conveyance distance between index tables. Therefore, according to the above aspect, it is possible to realize a smaller and faster inspecting device.

An inspecting device in accordance with a third aspect of the present invention employs the following configuration, in addition to the configuration of the inspecting device in accordance with the second aspect. That is, the inspecting device in accordance with the third aspect employs a configuration in which the device includes a first device and a second device; and in the device transferring operation, the arm concurrently (i) places, on the second index table, the first device obtained, at the first position, from the first index table and (ii) places, on the first index table, the second device obtained, at the second position, from the second index table.

According to the above aspect, it is possible to concurrently (i) transfer a first device from a first index table to a second index table and (ii) transfer a second device from the second index table to the first index table. Therefore, according to the above aspect, it is possible to realize a smaller and faster inspecting device.

An inspecting device in accordance with a fourth aspect of the present invention employs the following configuration, in addition to the configuration of the inspecting device in accordance with any one of the first through third aspects. That is, the inspecting device in accordance with the fourth aspect employs a configuration in which the inspecting device further includes: a third testing device configured to test, in the second environment, the device placed on the second index table; and a fourth testing device configured to test, in the first environment, the device placed on the first index table.

According to the above aspect, it is possible to efficiently carry out two kinds of tests in each of a first environment and a second environment.

An inspecting device in accordance with a fifth aspect of the present invention employs the following configuration, in addition to the configuration of the inspecting device in accordance with the fourth aspect. That is, the inspecting device in accordance with the fifth aspect employs a configuration in which one of the first testing device and the fourth testing device carries out a dynamic characteristic test, and the other of the first testing device and the fourth testing device carries out a static characteristic test; and one of the second testing device and the third testing device carries out a dynamic characteristic test, and the other of the second testing device and the third testing device carries out a static characteristic test.

According to the above aspect, it is possible to efficiently carry out a dynamic characteristic test and a static characteristic test in each of a first environment and a second environment.

An inspecting device in accordance with a sixth aspect of the present invention employs the following configuration, in addition to the configuration of the inspecting device in accordance with any one of the first through fifth aspects. That is, the inspecting device in accordance with the sixth aspect employs a configuration in which one of the first environment and the second environment is a room-temperature environment, and the other of the first environment and the second environment is a high-temperature environment in which a temperature is higher than that in the room-temperature environment.

According to the above aspect, it is possible to efficiently carry out a dynamic characteristic test and a static characteristic test in each of a room-temperature environment and a high-temperature environment.

An inspecting device in accordance with a seventh aspect of the present invention employs the following configuration, in addition to the configuration of the inspecting device in accordance with the sixth aspect. That is, the inspecting device in accordance with the seventh aspect employs a configuration in which one of the first index table and the second index table on which one the device is tested in the high-temperature environment includes therein a heater for realizing the high-temperature environment.

According to the above aspect, it is possible to test a device in a high-temperature environment without providing a mechanism for heating the device.

An inspecting device in accordance with an eighth aspect of the present invention employs a configuration in which the device is a semiconductor device, in addition to the configuration of the inspecting device in accordance with any one of the first through seventh aspects. According to the above aspect, it is possible to realize an inspecting device which efficiently tests a semiconductor device in each of different environments, without causing an unnecessary increase in size of the inspecting device and an unnecessary decrease in inspection speed.

### [Supplementary note]

The present invention is not limited to the above embodiments, but can be altered by a skilled person in the art within the scope of the claims. The imvention is defined by the appended claims.

### Reference Signs List

- 1: Inspecting device
- 11: First index table
- 12: Second index table
- 13: Arm
- 14: Mount collecting and supplying unit
- 15: First testing device (for carrying out a dynamic characteristic test in a room-temperature environment)
- 16: Second testing device (for carrying out a dynamic characteristic test in a high-temperature environment)
- 17: Third testing device (for carrying out a static characteristic test in a high-temperature environment)
- 18: Fourth testing device (for carrying out a static characteristic test in a room-temperature environment)

## Claims

1. An inspecting device (1) comprising:
- a first index table (11);
- a second index table (12);
- an arm (13) configured to conduct a device transferring operation of transferring a device (DUT) between the first index table (11) and the second index table (12);
- a first testing device (15) configured to test, in a first environment, the device (DUT) placed on the first index table (11); and
- a second testing device (16) configured to test, in a second environment which is different from the first environment, the device (DUT) placed on the second index table (12).

2. The inspecting device (1) as set forth in claim 1, wherein:
- in the device transferring operation, the arm (13) obtains, at a first position, the device (DUT) from the first index table (11) and places, at a second position, the device (DUT) on the second index table (12);
- the first position is a position on a first conveyance route which position is the closest to the second index table (12), the first conveyance route being a conveyance route along which the device (DUT) is conveyed by the first index table (11); and
- the second position is a position on a second conveyance route which position is the closest to the first index table (11), the second conveyance route being a conveyance route along which the device (DUT) is conveyed by the second index table (12).

3. The inspecting device (1) as set forth in claim 2, wherein:
- the device (DUT) includes a first device and a second device; and
- in the device transferring operation, the arm (13) concurrently
(i) places, on the second index table (12), the first device obtained, at the first position, from the first index table (11) and
(ii) places, on the first index table (11), the second device obtained, at the second position, from the second index table (12).

4. The inspecting device (1) as set forth in any one of claims 1 through 3, further comprising:
- a third testing device (17) configured to test, in the second environment, the device (DUT) placed on the second index table (12); and
- a fourth testing device (18) configured to test, in the first environment, the device (DUT) placed on the first index table (11).

5. The inspecting device (1) as set forth in claim 4, wherein:
- one of the first testing device (15) and the fourth testing device (18) carries out a dynamic characteristic test, and the other of the first testing device (15) and the fourth testing device (18) carries out a static characteristic test; and
- one of the second testing device (16) and the third testing device (17) carries out a dynamic characteristic test, and the other of the second testing device (16) and the third testing device (17) carries out a static characteristic test.

6. The inspecting device (1) as set forth in any one of claims 1 through 5, wherein one of the first environment and the second environment is a room-temperature environment, and the other of the first environment and the second environment is a high-temperature environment in which a temperature is higher than that in the room-temperature environment.

7. The inspecting device (1) as set forth in claim 6, wherein one of the first index table (11) and the second index table (12) on which one the device (DUT) is tested in the high-temperature environment includes therein a heater for realizing the high-temperature environment.

8. The inspecting device (1) as set forth in any one of claims 1 through 7, wherein the device (DUT) is a semiconductor device.

## Patentansprüche

1. Untersuchungsvorrichtung (1), aufweisend:
- einen ersten Schalttisch (11);
- einen zweiten Schalttisch (12);
- einen Arm (13), welcher eingerichtet ist, einen Vorrichtungsübertragungsvorgang des Übertragens einer Vorrichtung (DUT) zwischen dem ersten Schalttisch (11) und dem zweiten Schalttisch (12) durchzuführen;
- eine erste Prüfvorrichtung (15), welche eingerichtet ist, die Vorrichtung (DUT), welche auf dem ersten Schalttisch (11) angeordnet ist, in einer ersten Umgebung zu prüfen; und
- eine zweite Prüfvorrichtung (16), welche eingerichtet ist, die Vorrichtung (DUT), welche auf dem zweiten Schalttisch (12) angeordnet ist, in einer zweiten Umgebung, welche sich von der ersten Umgebung unterscheidet, zu prüfen.

2. Untersuchungsvorrichtung (1) nach Anspruch 1, wobei:
- beim Vorrichtungsübertragungsvorgang der Arm (13) die Vorrichtung (DUT) an einer ersten Position vom ersten Schalttisch (11) erlangt, und die Vorrichtung (DUT) an einer zweiten Position auf dem zweiten Schalttisch (12) anordnet;
- die erste Position eine Position auf einer ersten Förderstrecke ist, welche am nächsten am zweiten Schalttisch (12) angeordnet ist, wobei die erste Förderstrecke eine Förderstrecke ist, entlang welcher die Vorrichtung (DUT) durch den ersten Schalttisch (11) befördert wird; und
- die zweite Position eine Position auf einer zweiten Förderstrecke ist, welche am nächsten am ersten Schalttisch (11) angeordnet ist, wobei die zweite Förderstrecke eine Förderstrecke ist, entlang welcher die Vorrichtung (DUT) durch den zweiten Schalttisch (12) befördert wird.

3. Untersuchungsvorrichtung (1) nach Anspruch 2, wobei:
- die Vorrichtung (DUT) eine erste Vorrichtung und eine zweite Vorrichtung aufweist; und
- beim Vorrichtungsübertragungsvorgang der Arm (13) gleichzeitig
(i) die erste, an der ersten Position vom ersten Schalttisch (11) erlangte Vorrichtung am zweiten Schalttisch (12) anordnet und
(ii) die zweite an der zweiten Position vom zweiten Schalttisch (12) erlangte Vorrichtung am ersten Schalttisch (11) anordnet.

4. Untersuchungsvorrichtung (1) nach einem der Ansprüche 1 bis 3, ferner aufweisend:
- eine dritte Prüfvorrichtung (17), welche eingerichtet ist, die Vorrichtung (DUT), welche auf dem zweiten Schalttisch (12) angeordnet ist, in der zweiten Umgebung zu prüfen; und
- eine vierte Prüfvorrichtung (18), welche dafür eingerichtet ist, die Vorrichtung (DUT), welche auf dem ersten Schalttisch (11) angeordnet ist, in der ersten Umgebung zu prüfen.

5. Untersuchungsvorrichtung (1) nach Anspruch 4, wobei:
- eine der Prüfvorrichtungen aus der Gruppe umfassend die erste Prüfvorrichtung (15) und die vierte Prüfvorrichtung (18) eine Prüfung einer dynamischen Eigenschaft durchführt, und die andere der Prüfvorrichtungen aus der Gruppe umfassend die erste Prüfvorrichtung (15) und die vierte Prüfvorrichtung (18) eine Prüfung einer statischen Eigenschaft durchführt; und
- eine der Prüfvorrichtungen aus der Gruppe umfassend die zweite Prüfvorrichtung (16) und die dritte Prüfvorrichtung (17) eine Prüfung einer dynamischen Eigenschaft durchführt, und die andere der Prüfvorrichtungen aus der Gruppe umfassend die zweite Prüfvorrichtung (16) und die dritte Prüfvorrichtung (17) eine Prüfung einer statischen Eigenschaft durchführt.

6. Untersuchungsvorrichtung (1) nach einem der Ansprüche 1 bis 5, wobei eine der Umgebungen aus der Gruppe umfassend die erste Umgebung und die zweite Umgebung eine Raumtemperaturumgebung ist, und die andere Umgebung aus der Gruppe umfassend die erste Umgebung und die zweite Umgebung eine Hochtemperaturumgebung ist, in welcher eine Temperatur höher ist, als jene in der Raumtemperaturumgebung.

7. Untersuchungsvorrichtung (1) nach Anspruch 6, wobei einer der Schalttische aus der Gruppe umfassend den ersten Schalttisch (11) und den zweiten Schalttisch (12), auf welchem die Vorrichtung (DUT) in der Hochtemperaturumgebung geprüft wird, eine darin angeordnete Heizvorrichtung zum Erzeugen der Hochtemperaturumgebung aufweist.

8. Untersuchungsvorrichtung (1) nach einem der Ansprüche 1 bis 7, wobei die Vorrichtung (DUT) eine Halbleitervorrichtung ist.

## Revendications

1. Dispositif d'inspection (1) comprenant :
- une première table d'index (11) ;
- une deuxième table d'index (12) ;
- un bras (13) configuré pour effectuer une opération de transfert de dispositif pour le transfert d'un dispositif (DUT) entre la première table d'index (11) et la deuxième table d'index (12) ;
- un premier dispositif de test (15) configuré pour tester, dans un premier environnement, le dispositif (DUT) placé sur la première table d'index (11) ; et
- un deuxième dispositif de test (16) configuré pour tester, dans un deuxième environnement différent du premier environnement, le dispositif (DUT) placé sur la deuxième table d'index (12).

2. Dispositif d'inspection (1) selon la revendication 1, dans lequel :
- dans l'opération de transfert de dispositif, le bras (13) obtient le dispositif (DUT) à une première position à partir de la première table d'index (11) et place le dispositif (DUT) sur la deuxième table d'index (12) à une deuxième position ;
- la première position est une position sur un premier trajet de transport, ladite position étant la plus proche de la deuxième table d'index (12), le premier trajet de transport étant un trajet de transport le long duquel le dispositif (DUT) est transporté par la première table d'index (11) ; et
- la deuxième position est une position sur un deuxième trajet de transport, ladite position étant la plus proche de la première table d'index (11), le deuxième trajet de transport étant un trajet de transport le long duquel le dispositif (DUT) est transporté par la deuxième table d'index (12).

3. Dispositif d'inspection (1) selon la revendication 2, dans lequel :
- le dispositif (DUT) inclut un premier dispositif et un deuxième dispositif ; et
- dans l'opération de transfert de dispositif, le bras (13)
(i) place le premier dispositif obtenu à la première position à partir de la première table d'index (11) sur la deuxième table d'index (12) et
(ii) place conjointement le deuxième dispositif obtenu à la deuxième position à partir de la deuxième table d'index (12) sur la première table d'index (11).

4. Dispositif d'inspection (1) selon l'une quelconque des revendications 1 à 3, comprenant en outre :
- un troisième dispositif de test (17) configuré pour tester, dans le deuxième environnement, le dispositif (DUT) placé sur la deuxième table d'index (12) ; et
- un quatrième dispositif de test (18) configuré pour tester, dans le premier environnement, le dispositif (DUT) placé sur la première table d'index (11).

5. Dispositif d'inspection (1) selon la revendication 4, dans lequel :
- l'un parmi le premier dispositif de test (15) et le quatrième dispositif de test (18) exécute un test de caractéristique dynamique, et l'autre parmi le premier dispositif de test (15) et le quatrième dispositif de test (18) exécute un test de caractéristique statique ; et
- l'un parmi le deuxième dispositif de test (16) et le troisième dispositif de test (17) exécute un test de caractéristique dynamique, et l'autre parmi le deuxième dispositif de test (16) et le troisième dispositif de test (17) exécute un test de caractéristique statique.

6. Dispositif d'inspection (1) selon l'une quelconque des revendications 1 à 5, dans lequel l'un parmi le premier environnement et le deuxième environnement est un environnement à température ambiante, et l'autre parmi le premier environnement et le deuxième environnement est un environnement à température élevée, dans lequel une température est plus élevée que dans l'environnement à température ambiante.

7. Dispositif d'inspection (1) selon la revendication 6, dans lequel l'une parmi la première table d'index (11) et la deuxième table d'index (12) sur laquelle le dispositif (DUT) est testé dans l'environnement à température élevée inclut un chauffage destiné à créer l'environnement à température élevée.

8. Dispositif d'inspection (1) selon l'une quelconque des revendications 1 à 7, dans lequel le dispositif (DUT) est un dispositif semiconducteur.
